# EUROPÄISCHE PATENTSCHRIFT

(11) **EP 3 970 180 B1**
(45) Veröffentlichungstag und Bekanntmachung des Hinweises auf die Patenterteilung: **07.05.2025**
(21) Anmeldenummer: 20728419.1
(22) Anmeldetag: 14.05.2020
(51) Int. Cl.: H01J 37/317, H01J 37/302

(54) **VORRICHTUNG UND VERFAHREN ZUR IMPLANTATION VON TEILCHEN IN EIN SUBSTRAT**
DEVICE AND METHOD FOR IMPLANTING PARTICLES INTO A SUBSTRATE
DISPOSITIF ET PROCÉDÉ D'IMPLANTATION DE PARTICULES DANS UN SUBSTRAT

(30) Priorität: 15.05.2019 DE 102019112773
(43) Veröffentlichungstag der Anmeldung: 23.03.2022
(60) Teilanmeldung: 25161322.0
(73) Patentinhaber: mi2-factory GmbH, 07745 Jena (DE)
(72) Erfinder: CSATO, Constantin, 95236 Stammbach (DE); KRIPPENDORF, Florian, 07743 Jena (DE)
(74) Vertreter: Wächter, Jochen
(86) Internationale Anmeldenummer: PCT/EP2020/063555
(87) Internationale Veröffentlichungsnummer: WO 2020/229638

(56) Entgegenhaltungen:
- WO-A1-2017/174597
- DE-A1- 102005 061 663
- JP-A- 2013 222 893
- US-A- 4 278 475
- US-A1- 2008 128 641
- US-A1- 2018 350 557
- THIEBERGER P ET AL: "Novel high-energy ion implantation facility using a 15?MV Tandem Van de Graaff accelerator", NUCLEAR INSTRUMENTS & METHODS IN PHYSICS RESEARCH. SECTION B: BEAM INTERACTIONS WITH MATERIALS AND ATOMS, vol. 442, 17 January 2019 (2019-01-17), pages 36 - 40, XP085593505, ISSN: 0168-583X, DOI: 10.1016/J.NIMB.2019.01.016

## Beschreibung

Die Erfindung betrifft eine Vorrichtung und ein Verfahren zur Implantation von Teilchen in ein Substrat.

Zur Modifikation von Materialeigenschaften, wie etwa Leitfähigkeit oder Ladungsträgerlebensdauer in Halbleitermaterialien, werden hochenergetische Ionenstrahlen eingesetzt. Typische Primärenergien der Ionen liegen oberhalb von 500keV, typische Halbleitermaterialien sind Silizium, Siliziumkarbid, Galliumarsenid, Cadmiumtellurid, Zinkselenid, Galliumnitrid etc. Mittels hochenergetischer Ionenstrahlen können aber auch die Eigenschaften von nicht halbleitenden Materialien, wie etwa Quarzglas, Lithiumniobat, Kaliumtitanylphosphat oder auch Kunststoffen, wie etwa PMMA modifiziert werden.

In den vergangenen Jahren wurde ein neues Hochenergieimplantationsverfahren, die sogenannte energiegefilterte Implantation, im Markt etabliert. In kommerziell ausgerichteten mikrotechnischen Produktionsprozessen sollen mittels Ionenimplantation, maskiert oder nicht maskiert, Dotierungen bzw. Punktdefekte in halbleitenden oder nicht halbleitenden Materialien mit vordefinierten Tiefenprofilen im Tiefenbereich von wenigen Nanometern bis hin zu einigen 10 Mikrometern erzeugt werden. Zur Realisierung solcher Dotiertiefenprofile dienen sogenannte Energiefilter für Ionenimplantation.

In solchen Anlagen werden die in speziellen Ionenquellen erzeugten Ionen durch aufwändige Hochenergiebeschleuniger auf die erforderliche Primärenergie gebracht. Die Anlagen sind in der Regel sehr komplex und haben einen großen Platzbedarf. Dies führt zu hohen Kosten bei der Errichtung von Gebäuden und zu hohen Anschaffungspreisen der Beschleunigermaschinen. Die Einstellung der passenden Energie für jede Sorte von Ionenstrahlen ist zudem aufwändig und oft auch schwer reproduzierbar.

Bei den bislang in den meisten Fällen für die Hochenergie-Waferimplantation verwendeten elektrostatischen Tandembeschleunigern oder Tandetronbeschleunigern müssen außerdem auf der Niederenergieseite negative Ionen eingeschossen werden, wodurch der verfügbare Strom für einige Elemente, wie etwa Aluminium, begrenzt wird. WO2017/174597A1 und DE 10 2005061663A1 zeigen Beispiele zur Ionenimplantation unter Verwendung von Energiefiltern in Form mikrostrukturierter Membrane.

Die Aufgabe der Erfindung liegt darin, eine Vorrichtung und ein Verfahren zur Implantation von Teilchen in ein Substrat anzugeben, die besonders kompakt und zuverlässig sind.

Gemäß einem ersten Aspekt der vorliegenden Erfindung umfasst die Vorrichtung zur Implantation von Teilchen in ein Substrat eine Teilchenquelle und einen Teilchenbeschleuniger zum Erzeugen eines Ionenstrahls aus positiv geladenen Ionen sowie eine Substrathalterung. Außerdem umfasst die Vorrichtung einen Energiefilter, der zwischen dem Teilchenbeschleuniger und der Substrathalterung angeordnet ist, wobei der Energiefilter eine mikrostrukturierte Membran mit einem vordefinierten Strukturprofil zur Einstellung eines durch die Implantation hervorgerufenen Dotierstofftiefenprofils und/oder Defekttiefenprofils im Substrat ist. Die Vorrichtung weist außerdem mindestens ein passives Abbremselement für den Ionenstrahl auf, das zwischen dem Teilchenbeschleuniger und der Substrathalterung und beabstandet vom Energiefilter angeordnet ist.

Mit dieser Ausgestaltung ist es möglich, dem Ionenstrahl auf gezielte Weise Energie zu entziehen und somit die gewünschte Energie für die Implantation der Teilchen in das Substrat einzustellen.

In einer bevorzugten Ausgestaltung ist das passive Abbremselement eine planare Membran.

Die Dicke der planaren Membran beträgt vorzugsweise zwischen 0,5 µm und 100 µm, mehr bevorzugt zwischen 2 µm und 30 µm, und besonders bevorzugt zwischen 4 µm und 15 µm. Das Material der planaren Membran ist bevorzugt aus einem der folgenden Materialien ausgewählt: Silizium, Wolfram, Kohlenstoff, Titan. Diese Materialien sind besonders geeignet für eine hohe Energiedissipation sowie hohe mechanische Membranstabilität. Ebenso sind Compound-Materialien denkbar, z.B. mit Bleianteilen für eine hohe Abbremseffizienz, oder mehrschichtige Materialien mit Schichten ähnlicher thermischer Ausdehnungseigenschaften.

Erfindungsgemäß ist das passive Abbremselement zwischen Teilchenbeschleuniger und Energiefilter und/oder in Strahlrichtung hinter dem Energiefilter angeordnet. Durch Anordnung zwischen Teilchenbeschleuniger und Energiefilter wird sichergestellt, dass auf den Energiefilter lediglich der Ionenstrahl mit reduzierter Energie trifft und somit im Energiefilter lediglich die maximal notwendige Leistung dissipiert wird. Der Abstand zwischen dem passiven Abbremselement und dem Energiefilter ist dabei bevorzugt zwischen 0,5 cm und 50 cm, mehr bevorzugt zwischen 0,7 cm und 10 cm, und besonders bevorzugt zwischen 1 cm und 2 cm.

Erfindungsgemäß ist das passive Abbremselement schwenkbar oder verschiebbar gelagert, um auch bei fester Energie des vom Teilchenbeschleuniger gelieferten Ionenstrahls eine Variation der Energie des auf das Substrat treffenden Ionenstrahls zu erzielen.

Auf diese Weise ist es möglich, das passive Abbremselement zu beliebigen Zeitpunkten in den Ionenstrahl oder aus dem Ionenstrahl zu bewegen. Insbesondere wenn eine Mehrzahl von passiven Abbremselementen vorliegt, kann damit die Einstellung der gewünschten Energiereduktion des Ionenstrahls auf einfache Weise erfolgen.

Das Verfahren zur Implantation von Teilchen in ein Substrat mit der oben beschriebenen Vorrichtung umfasst folgende Schritte:
- Erzeugen eines Ionenstrahls aus positiv geladenen Ionen mittels Teilchenquelle und Teilchenbeschleuniger;
- Bestrahlen des von der Substrathalterung gehaltenen Substrats mit dem Ionenstrahl unter Zwischenschaltung des passiven Abbremselements und des Energiefilters.

Bei diesem Verfahren ist es besonders bevorzugt, dass der Teilchenbeschleuniger bauartbedingt für jede Ionensorte lediglich eine feste Energie pro Nukleon liefern kann. Ebenso ist es möglich, dass der Teilchenbeschleuniger bauartbedingt lediglich Ionen im Energiebereich von 1 bis 50 MeV liefern kann, wobei bauartbedingt weniger als zehn, bevorzugt höchstens fünf, einstellbare Energien des Ionenstrahls möglich sind. Eine Variation der Energie des auf das Substrat treffenden Ionenstrahls erfolgt dann unter Verwendung einer geeigneten Auswahl von Zahl und Eigenschaften, wie Material und/oder Dicke, des Abbremselements oder der Abbremselemente, durch die der Ionenstrahl nach dem Teilchenbeschleuniger hindurchtritt. Bei dieser Ausgestaltung können die Herstellkosten und Abmessungen des Teilchenbeschleunigers auf ein Minimum reduziert werden. Außerdem kann die Energieeinstellung des Ionenstrahls mittels der oben genannten Auswahl besonders reproduktiv und zuverlässig für alle gewünschten Energien des Ionenstrahls erfolgen. Zudem entfallen die bei der freien Variation der Energie des Ionenstrahls im Teilchenbeschleuniger üblicherweise anfallenden Probleme wie der hohe steuerungstechnische Aufwand.

In einer bevorzugten Ausgestaltung liegt außerdem mindestens eines der Abbremselemente in mehrfacher Ausfertigung vor und diese identischen Abbremselemente werden abwechselnd in den Weg des Ionenstrahls gebracht, bevorzugt rotiert. Auf diese Weise kann die Strahlenbelastung und Erhitzung jedes einzelnen identischen Abbremselements reduziert werden. Dies gelingt auf vorteilhafte Weise, indem die identischen Abbremselemente von derselben Halterung getragen werden und die Halterung in einer Ebene senkrecht zum Ionenstrahl gedreht wird.

Zusätzlich können auch mehrere identische Energiefilter vorliegen, die abwechselnd in den Weg des Ionenstrahls gebracht werden, wobei die Energiefilter und die Abbremselemente vorzugsweise vom selben Drehmechanismus angetrieben sind. Die Strahlenbelastung und Erhitzung des einzelnen Energiefilters werden auf diese Weise reduziert. Die Halterungen von Abbremselement und Energiefilter liegen dann in mindestens zwei in Richtung des lonenstrahls hintereinander angeordneten Ebenen, wobei bevorzugt in der ersten Ebene die Abbremselemente und in der zweiten Ebene die Energiefilter angeordnet sind. Die Abbremselemente rotieren somit in der ersten Ebene und die Energiefilter rotieren in der zweiten Ebene.

Die oben beschriebene alternierende Verwendung identischer Abbremselemente und ggf. Energiefilter ermöglicht es außerdem, als Teilchenbeschleuniger einen Hochfrequenz-Linearbeschleuniger oder ein Zyklotron zu verwenden, der einen gepulsten Ionenstrahl mit einer Energie von 0,3 bis 3,0 MeV/Nukleon erzeugt. Aufgrund der wechselnden Verwendung können die einzelnen Abbremselemente und/oder Energiefilter auch einen Ionenstrahl mit derart hohen Energiepulsen hindurchtreten lassen, ohne Schaden zu nehmen oder zu überhitzen. Vorzugsweise sind der Takt und die Zeitdauer des Wechsels der Abbremselemente und/oder Energiefilter an den Takt und das Taktverhältnis des gepulsten Ionenstrahls angepasst. Es ist aber auch die Verwendung eines kontinuierlichen Ionenstrahls im selben Energiebereich denkbar.

Gemäß einem weiteren Aspekt der vorliegenden Erfindung umfasst das Verfahren zur Implantation von Teilchen in ein Substrat folgende Schritte:
- Bereitstellen einer Vorrichtung mit einer Teilchenquelle und einem Teilchenbeschleuniger, einer Substrathalterung, und einem Energiefilter, der zwischen dem Teilchenbeschleuniger und der Substrathalterung angeordnet ist, wobei der Energiefilter eine mikrostrukturierte Membran mit einem vordefinierten Strukturprofil zur Einstellung eines durch die Implantation hervorgerufenen Dotierstofftiefenprofils und/oder Defekttiefenprofils im Substrat ist;
- Erzeugen eines Ionenstrahls aus positiv geladenen Ionen mittels Teilchenquelle und Teilchenbeschleuniger; und
- Bestrahlen des von der Substrathalterung gehaltenen Substrats mit dem Ionenstrahl unter Zwischenschaltung des Energiefilters.

Der Teilchenbeschleuniger ist dabei ein Hochfrequenz-Linearbeschleuniger oder ein Zyklotron, der einen gepulsten oder kontinuierlichen Ionenstrahl mit einer Energie von 0,3 bis 3,0 MeV/Nukleon, bevorzugt 0,5 bis 3,0 MeV/Nukleon, mehr bevorzugt 1,0 bis 2,0 MeV/Nukleon, besonders bevorzugt 1,3 bis 1,7 MeV pro Nukleon erzeugt. Die Gesamtenergie des Ionenstrahls liegt vorzugsweise zwischen 1 und 50 MeV, besonders bevorzugt zwischen 4 und 40 MeV.

Vorzugsweise kann der Teilchenbeschleuniger bauartbedingt für jede Ionensorte lediglich eine feste Energie pro Nukleon liefern. Ebenso ist es möglich, dass der Teilchenbeschleuniger bauartbedingt lediglich Ionen im Energiebereich von 1 bis 50 MeV liefern kann, wobei bauartbedingt weniger als zehn einstellbare Energien des Ionenstrahls (vor dem Auftreffen auf das Abbremselement oder den Energiefilter) möglich sind. Auf diese Weise entfällt die aufwendige Einstellung zu vieler unterschiedlicher Energien des Ionenstrahls, was zu einer besseren Reproduzierbarkeit und deutlich verringerten Kosten führt.

In einer bevorzugten Ausgestaltung liegt das Tastverhältnis des gepulsten Ionenstrahls in einem Bereich von 1:20 bis 1:5, bevorzugt 1:12 bis 1:8.

Besonders bevorzugt erfolgt eine Variation der Energie des auf das Substrat treffenden Ionenstrahls unter Verwendung einer geeigneten Auswahl von Zahl und Eigenschaften, wie Material und/oder Dicke, des Abbremselements oder der Abbremselemente, durch die der Ionenstrahl nach dem Teilchenbeschleuniger hindurchtritt. Somit kann die Energie des lonenstrahls besonders exakt und reproduzierbar auf einen gewünschten Zielwert reduziert werden.

Bevorzugt wird der Ionenstrahl vor dem Auftreffen auf das oder die Abbremselemente aufgeweitet. Dadurch wird die effektive Fläche, auf die der Ionenstrahl trifft, erhöht und die auftreffende Stromdichte verringert. Diese Maßnahme kann zusammen mit der oben beschriebenen Variation der Energie durch geeignete Auswahl von Zahl, Material und/oder Dicke von Abbremselementen verwendet werden.

Es ist außerdem bevorzugt, dass ein Abbremselement in mehrfacher Ausfertigung vorliegt und diese identischen Abbremselemente abwechselnd in den Weg des Ionenstrahls gebracht werden, und/oder dass mehrere identische Energiefilter vorliegen, die abwechselnd in den Weg des Ionenstrahls gebracht werden. Die Strahlenbelastung und Erhitzung des einzelnen Energiefilters und/oder Abbremselements wird auf diese Weise reduziert.

In einer bevorzugten Ausgestaltung stellt die Teilchenquelle positive Ionen zur Verfügung. Damit ist es einfacher möglich, die gewünschte Höhe an Strom für die meisten Ionensorten bereitzustellen.

Weitere Vorteile und Eigenschaften der vorliegenden Erfindung ergeben sich aus der nachfolgenden Beschreibung unter Bezugnahme auf die Zeichnungen.
- Fig. 1: ist eine schematische Querschnittsansicht einer erfindungsgemäßen Vorrichtung zur Implantation von Teilchen in ein Substrat;
- Fig. 2: ist eine schematische Darstellung der Wirkweise eines Energiefilters, der in der Vorrichtung nach Fig. 1 Verwendung finden kann;
- Fig.3: ist eine schematische Darstellung verschiedener Dotierprofile, die mittels verschieden strukturierter Energiefilter erzeugt werden können;
- Fig. 4: ist eine schematische Querschnittsansicht einer alternativen Ausgestaltung der erfindungsgemäßen Vorrichtung zur Implantation von Teilchen in ein Substrat; und
- Fig. 5: ist eine schematische Querschnittsansicht einer weiteren alternativen Ausgestaltung der erfindungsgemäßen Vorrichtung zur Implantation von Teilchen in ein Substrat.

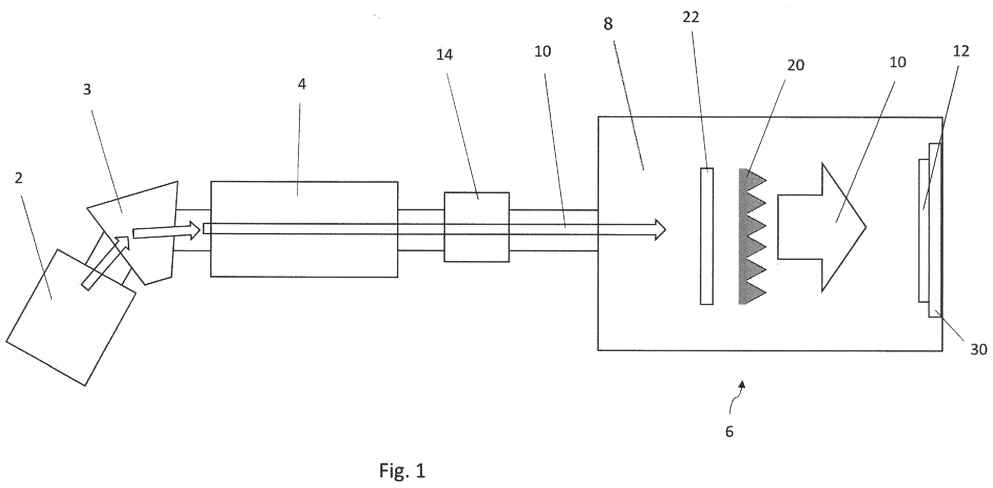

Die in Fig. 1 gezeigte Vorrichtung zur Implantation von Teilchen in ein Substrat weist eine Teilchenquelle 2, einen Teilchenbeschleuniger 4 und eine Endstation 6 mit einer Bestrahlungskammer 8 auf. In der Bestrahlungskammer 8 liegt üblicherweise ein Hochvakuum vor. In der Bestrahlungskammer 8 ist ein zu dotierendes Substrat 12 in einer Substrathalterung 30 aufgenommen.

Das Material des Substrats 12 ist vorzugsweise Siliziumkarbid (SiC). Es kommen aber auch andere Halbleitermaterialien wie Silizium, Galliumarsenid, Cadmiumtellurid, Zinkselenid, Galliumnitrid etc. in Frage. Ebenfalls als Material des Substrats 12 denkbar sind nicht halbleitende Materialien, wie etwa Quarzglas, Lithiumniobat, Kaliumtitanylphosphat oder auch Kunststoffe, wie etwa PMMA. Das Substrat 12 ist vorzugsweise als Wafer ausgebildet.

In der Teilchenquelle 2 werden Ionen vorzugsweise positiver Ladung erzeugt, durch den Analysiermagneten 3 wird die gewünschte Ionensorte ausgewählt und anschließend werden die positiv geladenen Ionen vom Teilchenbeschleuniger 4 beschleunigt, wodurch der beschleunigte Ionenstrahl 10 gebildet wird. Die Ionen des Ionenstrahls 10 sind bevorzugt aus Aluminium, Stickstoff, Wasserstoff, Helium, Bor, Phosphor, Kohlenstoff, Arsen oder Vanadium.

Der Teilchenbeschleuniger 4 ist bevorzugt ein Hochfrequenz-Linearbeschleuniger, in dem die Ionen mittels Hochfrequenzfeldern beschleunigt werden. Alternativ kann der Teilchenbeschleuniger 4 aber auch als Zyklotron oder als elektrostatischer Beschleuniger, wie z.B. Tandembeschleuniger, Tandetronbeschleuniger oder Single Ended Electrostatic-Beschleuniger, ausgestaltet sein. In der Ausführung als elektrostatisches Tandetron werden in der Teilchenquelle 2 zunächst negative Ionen erzeugt, beschleunigt, an einem Hochspannungsterminal umgeladen und dann analog wie im oben beschriebenen Fall nochmals beschleunigt.

Besonders bevorzugt ist es, wenn der Teilchenbeschleuniger 4 als einfach ausgebildeter Hochfrequenz-Linearbeschleuniger oder als Zyklotron ausgestaltet ist, der den Ionenstrahl 10 nur auf eine festgelegte Energie pro Nukleon beschleunigen kann. Die Kontrolleinheit des Hochfrequenz-Linearbeschleunigers oder Zyklotrons kann die Energie pro Nukleon bauartbedingt nicht ändern, sondern dient lediglich zur Kontrolle der zum Betrieb der Anlage nötigen Parameter. Ebenso ist es denkbar, dass bauartbedingt weniger als zehn, bevorzugt höchstens fünf, einstellbare Energien des Ionenstrahls 10 möglich sind. Damit wird der steuerungstechnische Aufwand im Teilchenbeschleuniger 4 erheblich gegenüber einer freien Variation der Energie des vom Teilchenbeschleuniger gelieferten Ionenstrahls 10 reduziert.

Der Hochfrequenz-Linearbeschleuniger oder das Zyklotron liefert bauartbedingt bevorzugt einen gepulsten Ionenstrahl 10 aus positiv geladenen Ionen mit einer Energie von 0,3 bis 3,0 MeV/Nukleon, bevorzugt 0,5 bis 3,0 MeV/Nukleon, mehr bevorzugt 1,0 bis 2,0 MeV/Nukleon, besonders bevorzugt 1,3 bis 1,7 MeV pro Nukleon. Der so erzeugte Ionenstrahl 10 lässt sich durch ein Tastverhältnis des Ionenstroms innerhalb eines Zeitfensters beschreiben. Beispielsweise kann das Tastverhältnis (An:Aus) des Ionenstrahls 10 zwischen 1:20 und 1:5, bevorzugt zwischen 1:12 und 1:8 betragen.

Beispielhaft sei ein Tastverhältnis von 1:10 erläutert. Da hierbei nur 10% des Zeitfensters für die effektive Bestrahlung zur Verfügung steht, muss bei einem derart gepulsten Ionenstrahl innerhalb des Pulses eine Stromstärke von 100 µA vorgehalten werden, wenn man einen mittleren Ionenstrom von 10 µA erreichen will.

Die Frequenz der Pulse des Ionenstrahls 10 liegt zwischen 1 Hz und 2 kHz, bevorzugt zwischen 3 Hz und 500 Hz, und besonders bevorzugt zwischen 7 Hz und 200 Hz.

Der Ionenstrahl 10 kann auch kontinuierlich sein bei gleicher Energie.

Der hochenergetische Ionenstrahl 10 wird üblicherweise vor Eintritt in die Endstation 6 in einer Ionenoptik 14 geformt und anschließend in die Bestrahlungskammer 8 geführt. Dort wird die Energie des Ionenstrahls 10 durch einen Energiefilter 20 aufgespreizt und er trifft auf das zu bestrahlende Substrat 12.

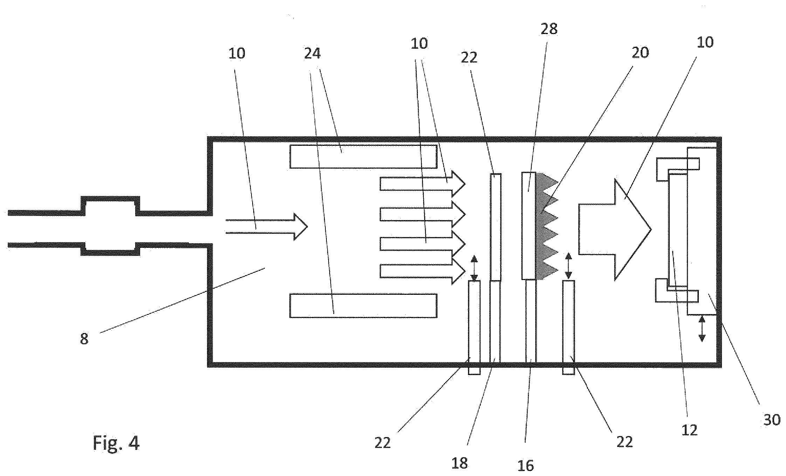

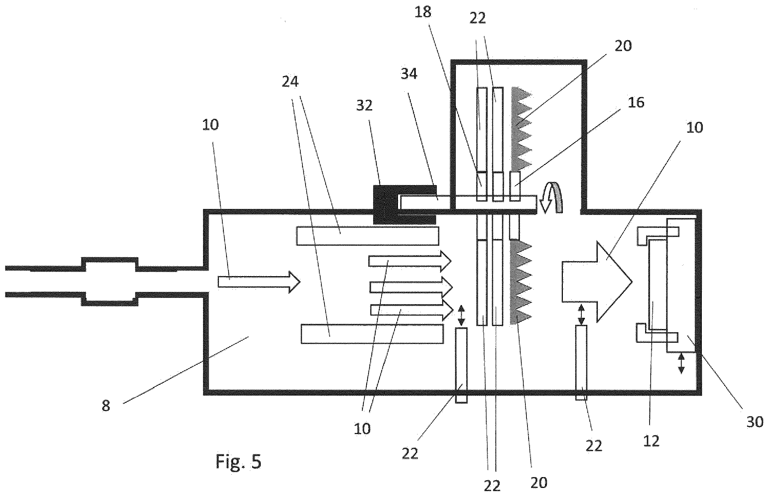

Wie aus Fig. 4 und 5 hervorgeht, muss die Substrathalterung 30 nicht stationär sein, sondern kann optional mit einer Einrichtung zum Verschieben des Substrates 12 in x-y (in der Ebene senkrecht zur Blattebene) versehen sein. Als Substrathalterung 30 kommt außerdem auch ein Waferrad in Betracht, auf welchem die zu implantierenden Substrate 12 fixiert werden und das sich während der Implantation dreht. Auch eine Verschiebung der Substrathalterung 30 in Strahlrichtung (z-Richtung) kann möglich sein. Weiterhin kann die Substrathalterung 30 optional mit einer Heizung oder Kühlung versehen sein.

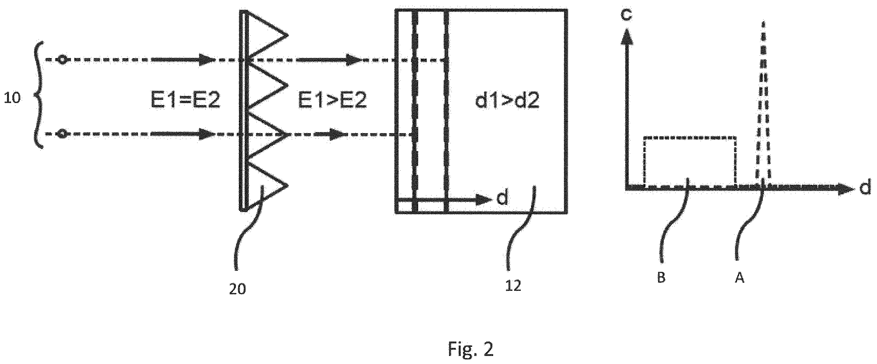

Das Grundprinzip des Energiefilters 20 ist in Fig. 2 dargestellt. Der monoenergetische lonenstrahl 10 wird beim Durchtritt durch den als mikrostrukturierte Membran ausgestalteten Energiefilter 20 abhängig vom Eintrittsort in seiner Energie modifiziert. Die resultierende Energieverteilung der Ionen des Ionenstrahls 10 führt zu einer Modifikation des Tiefenprofils des implantierten Stoffes in der Matrix des Substrats 12. E1 bezeichnet die Energie eines ersten Ions, E2 bezeichnet die Energie eines zweiten Ions, c bezeichnet die Dotierkonzentration und d bezeichnet die Tiefe im Substrat 12. Im Diagramm rechts ist die übliche Gaußverteilung mit Bezugszeichen A gekennzeichnet, die ohne Einsatz eines Energiefilters 20 entsteht. Hingegen ist beispielhaft mit Bezugszeichen B eine Rechteckverteilung skizziert, die bei Einsatz eines Energiefilters 20 erzielt werden kann.

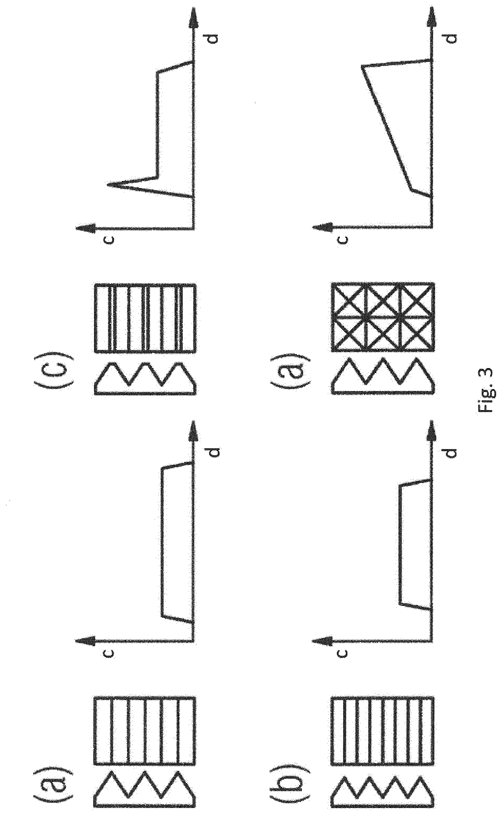

Die in Fig. 3 gezeigten Layouts bzw. dreidimensionalen Strukturen von Energiefiltern 20 zeigen die prinzipiellen Möglichkeiten, mittels Energiefilter 20 eine Vielzahl von Dotierstofftiefenprofilen oder Defekttiefenprofilen zu erzeugen. c bezeichnet wiederum die Dotierkonzentration und d bezeichnet wiederum die Tiefe im Substrat 12. Die Filterstrukturprofile können im Prinzip miteinander kombiniert werden, um neue Filterstrukturprofile und somit neue Dotierstofftiefenprofile oder Defekttiefenprofile zu erhalten.

Derartige Energiefilter 20 sind in der Regel aus Silizium hergestellt. Sie besitzen eine Dicke von zwischen 3 µm und 200 µm, vorzugsweise zwischen 5 µm und 50 µm und besonders bevorzugt zwischen 7 µm und 20 µm. Sie können in einem Filterrahmen (nicht dargestellt) gehalten sein. Der Filterrahmen kann austauschbar in einer Filterhalterung 16 (siehe Fig. 4) aufgenommen sein.

Gemäß einem Aspekt der Erfindung ist im Strahlengang des Ionenstrahls 10 mindestens ein passives Abbremselement 22 angeordnet. Das Abbremselement 22 ist zwischen dem Teilchenbeschleuniger 4 und der Substrathalterung 30 und beabstandet vom Energiefilter 20 angeordnet.

Bevorzugt weist das passive Abbremselement 22 eine planare Membran aus einem der folgenden Materialien auf: Silizium, Wolfram, Kohlenstoff, Titan. Kriterien für die Materialauswahl sind u.a. die Herstellbarkeit dünner Membrane, das Abbremsvermögen des Materials, die Wärmekapazität bzw. Wärmeabstrahlfähigkeit des Materials sowie die potentielle Gefahr von Kontaminationen des Substrats 12.

Die Dicke der planaren Membran beträgt zwischen 0,5 µm und 100 µm, bevorzugt zwischen 2 µm und 30 µm, und mehr bevorzugt zwischen 4 µm und 15 µm.

Jedes Abbremselement 22 kann in einem Rahmen (nicht dargestellt) gehalten sein. Der Rahmen kann austauschbar in der Halterung 18 (siehe Fig. 4) aufgenommen sein.

In Fig. 1 ist genau ein passives Abbremselement 22 dargestellt, das zwischen Teilchenbeschleuniger 4 und Energiefilter 20 und bevorzugt innerhalb der Bestrahlungskammer 8 angeordnet ist.

Fig. 4 zeigt einen Ausschnitt einer alternativen Ausgestaltung der Vorrichtung aus Fig. 1. Gleiche Elemente sind mit denselben Bezugszeichen versehen. Ohne weitere Angaben gelten zu den einzelnen Elementen die oben zu Fig. 1 gemachten Ausführungen, ebenso zu nicht dargestellten Komponenten.

Insbesondere wenn, wie oben beschrieben, ein Teilchenbeschleuniger 4 verwendet wird, der einen gepulsten Ionenstrahl 10 liefert, wird der Ionenstrahl 10 vorzugsweise in einer Strahlaufweitungsvorrichtung 24 vor dem Auftreffen auf das Abbremselement 22 bzw. auf den Energiefilter 20 aufgeweitet.

In der in Fig. 4 dargestellten Ausführungsform sind mehrere passive Abbremselemente 22 vorgesehen. Wie dargestellt können Abbremselemente 22 in Strahlrichtung vor oder hinter dem Energiefilter 20 angeordnet sein und werden üblicherweise von einer Halterung 18 gehalten.

Jedes der Abbremselemente 22 ist beabstandet von dem nächsten Abbremselement 22 bzw. beabstandet vom Energiefilter 20 angeordnet. Der Abstand zwischen zwei aufeinander folgenden Abbremselementen 22 bzw. zwischen einem Abbremselement 22 und dem Energiefilter 20 beträgt üblicherweise zwischen 0,5 cm und 50 cm, bevorzugt zwischen 0,7 cm und 10 cm, und mehr bevorzugt zwischen 1 cm und 2 cm.

Wie beim ersten und letzten Abbremselement 22 dargestellt, kann jedes passive Abbremselement 22 senkrecht zur Strahlrichtung verschiebbar gelagert sein. Bei den verschiebbaren Abbremselementen 22 sind zur Vereinfachung die Halterungen 18 nicht dargestellt.

Um auch bei fester Energie des vom Teilchenbeschleuniger 4 gelieferten Ionenstrahls 10 eine Variation der Energie des auf das Substrat 12 treffenden Ionenstrahls 10 zu erzielen, kann nun beispielsweise die Zahl der Abbremselemente 22, durch die der Ionenstrahl 10 nach dem Teilchenbeschleuniger 4 hindurchtritt, variiert werden. Alternativ oder zusätzlich kann durch eine geeignete Auswahl von Eigenschaften, wie Material und/oder Dicke, des Abbremselements 22 oder der Abbremselemente 22, eine Variation der Energie des auf das Substrat 12 treffenden Ionenstrahls 10 hervorgerufen werden.

Konkret müssen alle oben genannten Parameter so eingestellt werden, dass das Abbremsvermögen aller Abbremselemente 22 und des Energiefilters 20 im Strahlengang so gewählt wird, dass für die jeweilige Applikation (Tiefe des Dotierstoffprofils bzw. Defektprofils im Substrat 12) die Energie des Ionenstrahls 10 auf die gewünschte Energie reduziert wird. Die Auswahl und Ausgestaltung der Abbremselemente 22 bestimmt somit, ausgehend von der beschleunigerseitig gelieferten festen Energie pro Nukleon, zusammen mit dem Energiefilter 20 maßgeblich die Primärenergie des Ionenstrahls 10 für die jeweilige Anwendung.

Zusätzlich ist es möglich, eine passive Abbremseinheit 28, die vorzugsweise als planare Membranschicht ausgebildet ist, monolithisch mit dem Energiefilter 20 zu verbinden. Weil Energiefilter 20 in der Regel aus Silizium hergestellt sind, wird auch die Abbremseinheit 28 bevorzugt aus Silizium hergestellt. Damit vermeidet man Verspannungseffekte die durch das unterschiedliche thermische Ausdehnungsverhalten von verschiedenen Materialien herrühren können. Es sind aber auch Ausführungsformen von Energiefilter 20 und Abbremseinheit 28 vorstellbar, die für Energiefilter 20 und Abbremseinheit 28 unterschiedliche Materialien vorsehen. In solchen Fällen können Energiefilter 20 und Abbremseinheit 28 nicht monolithisch aufgebaut sein, sondern es muss eine mechanisch feste, gut wärmeleitende Verbindung zwischen Energiefilter 20 und Abbremseinheit 28 bestehen.

Die Ausführungsform aus Fig. 5 entspricht in vielen Aspekten der Ausführungsform aus Fig. 4. Hinzugekommen ist eine Einrichtung, die eine Rotationsbewegung eines oder mehrerer Abbremselemente 22 und/oder eines oder mehrerer Energiefilter 20 ermöglicht.

In diesem Fall ist mindestens ein Abbremselement 22 und/oder mindestens ein Energiefilter 20 an einer Welle 34 befestigt, die wiederum drehbar gelagert ist und von einem Drehmechanismus 32 angetrieben ist. Somit kann das jeweilige Abbremselement 22 und/oder der jeweilige Energiefilter 20 in den oder aus dem Strahlengang bewegt werden. Als Antriebskomponente des Drehmechanismus 34 kommt insbesondere ein Servomotor in Frage.

Bei dieser Ausgestaltung ist es besonders bevorzugt, wenn, wie dargestellt, ein Abbremselement 22 in mehrfacher, vorzugsweise identischer, Ausfertigung vorliegt und diese Abbremselemente 22 abwechselnd in den Weg des Ionenstrahls 10 rotiert werden. Zusätzlich oder alternativ können auch mehrere, vorzugsweise identische, Energiefilter 20 vorliegen, die abwechselnd in den Weg des Ionenstrahls 10 gebracht werden. Die Halterungen 16, 18 von Energiefiltern 20 und Abbremselementen 22 können auch einstückig miteinander ausgebildet sein.

Wenn ein gepulster Ionenstrahl 10 vorliegt, wird die Bewegung der Energiefilter 20 und/oder der passiven Abbremselemente 22 in vorteilhafter Weise auf die periodische zeitliche Struktur des Ionenstrahls 10 abgestimmt. Dadurch wird sichergestellt, dass der Ionenpuls immer auf aktive Bereiche des Energiefilters 20 bzw. der Abbremselemente 22 trifft, und es wird verhindert, dass der lonenpuls immer auf die gleiche Stelle eines Energiefilters 20 bzw. eines Abbremselements 22 trifft. Die Abstimmung kann durch eine Rotationsbewegung pro Puls oder pro mehreren Pulsen, beispielsweise in einem Bereich pro 10-20 Pulsen erfolgen.

Allgemein gesprochen, soll die zeitliche Abstimmung von gepulstem Ionenstrahl 10 und rotierenden Energiefiltern 20 und/oder Abbremselementen 22 dazu führen, dass Energiefilter 20 und/oder Abbremselemente 22 im Mittel gleichmäßig bestrahlt werden, der Energieeintrag möglichst gleichmäßig verteilt wird und Totzeiten durch versehentlich bestrahlte Hilfs- oder Haltestrukturen der Energiefilter 20 bzw. der Abbremselemente 22 vermieden werden.

Eine Rotationsbewegung ist notwendig bei sehr hohen lonenströmen und sehr großer Differenz zwischen der beschleunigerseitigen und der substratseitigen Energie des Ionenstrahls 10. In diesen Fällen würde sich ein Abbremselement 22 und/oder ein Energiefilter 20 sehr stark aufheizen. Es ist daher notwendig, die effektive Fläche, auf die der beschleunigerseitige Ionenstrahl 10 trifft, zu erhöhen bzw. die auftreffende Stromdichte zu verringern.

Für die dissipierte Leistung in einem Abbremselement 22 oder in einem Energiefilter 20 gilt: dissipierte Leistung (im Element in Wärme umgewandelte Energie) = Strahlleistung minus transmittierte Leistung (Restleistung nach Durchqueren des Elements)

Die abwechselnde Verwendung von identischen Abbremselementen 22 bzw. die abwechselnde Verwendung von identischen Energiefiltern 20 ist bei dissipierten Leistungen oberhalb von 3 W/cm², vorzugsweise bereits oberhalb von 2 W/cm² sinnvoll.

Es sind in diesem Zusammenhang auch Ausführungsformen denkbar, die anstelle der Rotation eine Linearbewegung der Energiefilter 20 und/oder Abbremselemente 22 ermöglichen.

Ein erfindungsgemäßer Aspekt der Vorrichtung liegt darin, strukturierte Energiefilter 20 zusammen mit nicht strukturierten Abbremselementen 20 zur Energiemodifikation einzusetzen. Dies kann genutzt werden, um Teilchenbeschleuniger 4 drastisch zu vereinfachen, da diese so gebaut werden können, dass beispielsweise nur noch eine feste Energie pro Nukleon geliefert werden muss. Die applikationsspezifisch erforderliche Zielenergie des Ionenstrahls 10 wird dann durch gezielte Energiesubtraktion von der Energie des Primärstrahls eingestellt.

Die Anzahl der Abbremselemente 22 kann in jeder der oben beschriebenen Ausführungsformen variieren, ebenso deren räumliche Anordnung und Eigenschaften wie Material und Dicke. Es muss mindestens ein Abbremselement 22 vorliegen, das in Strahlrichtung vor und/oder hinter dem Energiefilter 20 angeordnet sein kann. Bestimmte einzelne Abbremselemente 22 aus den oben beschriebenen Ausführungsformen können auch separiert verwendet werden oder in beliebiger Kombination mit anderen Abbremselementen 22 aus anderen Ausführungsformen.

Bei Vorliegen einer Mehrzahl von Abbremselementen 22 können sich die einzelnen Abbremselemente 22 in ihren Eigenschaften unterscheiden oder sie können identisch ausgebildet sein.

Die Abbremselemente 22 und/oder der Energiefilter 20 können auch in Strahlrichtung verschiebbar sein, entweder einzeln relativ zueinander oder gemeinsam in ihrer Gesamtheit.

Die Abbremselemente 22 und Energiefilter 20 können auch in allen Ausführungsformen in einer durch Ventile verschließbaren separaten Vakuumkammer angeordnet werden, die innerhalb der Bestrahlungskammer 8 oder direkt an diese anschließend angeordnet ist.

## Patentansprüche

1. Vorrichtung zur Implantation von Teilchen in ein Substrat (12), mit
einer Teilchenquelle (2) und einem Teilchenbeschleuniger (4) zum Erzeugen eines Ionenstrahls (10) aus positiv geladenen Ionen;
einer Substrathalterung (30);
einem Energiefilter (20), der zwischen dem Teilchenbeschleuniger (4) und der Substrathalterung (30) angeordnet ist, wobei der Energiefilter (20) eine mikrostrukturierte Membran mit einem vordefinierten Strukturprofil zur Einstellung eines durch die Implantation hervorgerufenen Dotierstofftiefenprofils und/oder Defekttiefenprofils im Substrat (12) ist; und
mindestens einem passiven Abbremselement (22) für den Ionenstrahl (10), das zwischen dem Teilchenbeschleuniger (4) und der Substrathalterung (30) und beabstandet vom Energiefilter (20) angeordnet ist, wobei das mindestens eine passive Abbremselement (22) zwischen Teilchenbeschleuniger (4) und Energiefilter (20) angeordnet ist und/oder in Strahlrichtung hinter dem Energiefilter (20) angeordnet ist, **dadurch gekennzeichnet, dass**
das mindestens eine passive Abbremselement (22) schwenkbar oder verschiebbar gelagert ist, um auch bei fester Energie des vom Teilchenbeschleuniger (4) gelieferten Ionenstrahls (10) eine Variation der Energie des auf das Substrat (12) treffenden Ionenstrahls zu erzielen.

2. Vorrichtung nach Anspruch 1, **dadurch gekennzeichnet, dass** das mindestens eine passive Abbremselement (22) eine planare Membran aufweist.

3. Vorrichtung nach Anspruch 2, **dadurch gekennzeichnet, dass** die Dicke der planaren Membran zwischen 0,5 µm und 100 µm, bevorzugt zwischen 2 µm und 30 µm, mehr bevorzugt zwischen 4 µm und 15 µm, beträgt.

4. Vorrichtung nach Anspruch 2 oder 3, **dadurch gekennzeichnet, dass** das Material der planaren Membran aus einem der folgenden Materialien ausgewählt ist: Silizium, Wolfram, Kohlenstoff, Titan.

5. Vorrichtung nach einem der vorangehenden Ansprüche, **dadurch gekennzeichnet, dass** der Teilchenbeschleuniger (4) ein Hochfrequenz-Linearbeschleuniger oder ein Zyklotron ist.

6. Vorrichtung nach Anspruch 5, **dadurch gekennzeichnet, dass** der Teilchenbeschleuniger (4) einen gepulsten oder kontinuierlichen Ionenstrahl (10) mit einer Energie von 0,3 bis 3,0 MeV/Nukleon, bevorzugt 0,5 bis 3,0 MeV/Nukleon, mehr bevorzugt 1,0 bis 2,0 MeV/Nukleon, mehr bevorzugt 1,3 bis 1,7 MeV/Nukleon erzeugt.

7. Vorrichtung nach Anspruch 5 oder 6, **dadurch gekennzeichnet, dass** der Teilchenbeschleuniger (4) bauartbedingt für jede Ionensorte lediglich eine feste Energie pro Nukleon liefern kann, oder
dass der Teilchenbeschleuniger (4) bauartbedingt lediglich Ionen im Energiebereich von 1 bis 50 MeV liefern kann, wobei bauartbedingt weniger als zehn einstellbare Energien des Ionenstrahls (10) möglich sind.

8. Vorrichtung nach einem der vorangehenden Ansprüche, **dadurch gekennzeichnet, dass** Halterungen (16, 18) des Energiefilters (20) und des mindestens einen Abbremselements (22) einstückig miteinander ausgebildet sind.

9. Vorrichtung nach einem der vorangehenden Ansprüche, **dadurch gekennzeichnet, dass** das mindestens eine Abbremselement (22) und der Energiefilter (20) in einer durch Ventile verschließbaren separaten Vakuumkammer angeordnet sind, die innerhalb der Bestrahlungskammer (8) oder direkt an die Bestrahlungskammer (8) anschließend angeordnet ist.

10. Verfahren zur Implantation von Teilchen in ein Substrat (12) mit der Vorrichtung aus einem der Ansprüche 1 bis 9, mit folgenden Schritten:
- Erzeugen eines Ionenstrahls (10) aus positiv geladenen Ionen mittels Teilchenquelle (2) und Teilchenbeschleuniger (4); und
- Bestrahlen des von der Substrathalterung (30) gehaltenen Substrats (12) mit dem Ionenstrahl (10) unter Zwischenschaltung des mindestens einen passiven Abbremselements (22) und des Energiefilters (20).

11. Verfahren nach Anspruch 10, **dadurch gekennzeichnet, dass** eine Variation der Energie des auf das Substrat (12) treffenden Ionenstrahls (10) unter Verwendung einer geeigneten Auswahl von Zahl und Eigenschaften, wie Material und/oder Dicke, des Abbremselements (22) oder der Abbremselemente (22), durch die der Ionenstrahl (10) nach dem Teilchenbeschleuniger (4) hindurchtritt, erfolgt.

12. Verfahren nach Anspruch 10 oder 11, **dadurch gekennzeichnet, dass** ein Abbremselement (22) in mehrfacher Ausfertigung vorliegt und diese Abbremselemente (22) abwechselnd in den Weg des Ionenstrahls (10) gebracht, bevorzugt rotiert, werden.

13. Verfahren nach Anspruch 12, **dadurch gekennzeichnet, dass** mehrere Energiefilter (20) vorliegen, die abwechselnd in den Weg des Ionenstrahls (10) gebracht werden, wobei die Energiefilter (20) und die Abbremselemente (22) vom selben Drehmechanismus (32) angetrieben sind.

## Claims

1. A device for implanting particles in a substrate (12), comprising:
a particle source (2) and a particle accelerator (4) for generating an ion beam (10) of positively charged ions;
a substrate holder (30);
an energy filter (20) arranged between the particle accelerator (4) and the substrate holder (30), wherein the energy filter (20) is a microstructured membrane with a predefined structural profile for setting a dopant depth profile and/or a defect depth profile produced in the substrate (12) by the implanting; and
at least one passive braking element (22) for the ion beam (10), wherein the at least one passive braking element (22) is arranged between the particle accelerator (4) and the substrate holder (30) and is spaced apart from the energy filter (20), wherein the at least one passive braking element (22) is arranged between the particle accelerator (4) and the energy filter (20) and/or is arranged behind the energy filter (2) with respect to a direction of the ion beam,
**characterized in that**
the at least one passive braking element (22) is supported pivotably or slidably so as to achieve a variation of the energy of the ion beam striking the substrate (12) even in the case of a fixed energy of the ion beam (10) provided by the particle accelerator (4).

2. The device of claim 1, **characterized in that** the at least one passive braking element (22) comprises a planar membrane.

3. The device of claim 2, **characterized in that** the thickness of the planar membrane is between 0.5 µm and 100 µm, preferably between 2 µm and 30 µm, more preferably between 4 µm and 15 µm.

4. The device of claim 2 or 3, **characterized in that** the material of the planar membrane is selected from one of the following materials: silicon, tungsten, carbon, titanium.

5. The device of one of the preceding claims, **characterized in that** the particle accelerator (4) is a high-frequency linear accelerator or a cyclotron.

6. The device of claim 5, **characterized in that** the particle accelerator (4) generates a pulsed or continuous ion beam (10) with an energy of 0,3 to 3,0 MeV/nucleon, preferably of 0,5 to 3,0 MeV/nucleon, more preferably of 1,0 to 2,0 MeV/nucleon, more preferably of 1,3 to 1,7 MeV/nucleon.

7. The device of claim 5 or 6, **characterized in that** the particle accelerator (4) has a configuration which allows it to deliver only one fixed energy per nucleon for each ion species, or
**in that** the particle accelerator (4) has a configuration which allows it to deliver only ions in an energy range of 1 to 50 MeV, wherein the particle accelerator (4) has a configuration according to which only fewer than ten settable energies of the ion beam (10) are possible.

8. The device of one of the preceding claims, **characterized in that** holders (16, 18) of the energy filter (20) and of the at least one braking element (22) are configured as a single integral unit.

9. The device of one of the preceding claims, **characterized in that** the at least one braking element (22) and the energy filter (20) are arranged in a separate vacuum chamber which is configured to be sealed off by valves, wherein the vacuum chamber is arranged inside the irradiation chamber (8) or arranged in direct connection to the irradiation chamber (8).

10. A method for implanting particles in a substrate (12) by means of the device of one of claims 1 to 9, comprising the steps of:
- generating an ion beam (12) of positively charged ions by means of the particle source (2) and the particle accelerator (4); and
- irradiating the substrate (12) held by the substrate holder (30) with the ion beam (10) under interposition of the at least one passive braking element (22) and the energy filter (20).

11. The method of claim 10, **characterized in that** an energy of the ion beam (10) striking the substrate (12) is varied by use of an appropriate selection of the number of the braking element(s) (22), through which the ion beam (10) passes after leaving the particle accelerator (4), and an appropriate selection of properties of the braking element(s) (22), such as material and/or thickness.

12. The method of claim 10 or 11, **characterized in that** at least one braking element (22) is provided in multiple copies, and **in that** the copies of the at least one braking element (22) are alternately brought, preferably rotated, into the path of the ion beam (10).

13. The method of claim 12, **characterized in that** multiple energy filters (20) are provided, which are alternately moved into the path of the ion beam (10), wherein the energy filters (20) and the braking elements (22) are driven by the same rotational mechanism (32).

## Revendications

1. Dispositif d'implantation de particules dans un substrat (12), comportant
une source de particules (2) et un accélérateur de particules (4) pour générer un faisceau d'ions (10) d'ions chargés positivement ;
un support de substrat (30) ;
un filtre d'énergie (20), qui est disposé entre l'accélérateur de particules (4) et le support de substrat (30), dans lequel le filtre d'énergie (20) est une membrane microstructurée avec un profil structurel prédéfini pour ajuster un profil de profondeur de dopant et/ou un profil de profondeur de défaut dans le substrat (12) provoqué par l'implantation ; et
au moins un élément de décélération passif (22) pour le faisceau d'ions (10), qui est disposé entre l'accélérateur de particules (4) et le support de substrat (30) et espacé du filtre d'énergie (20), dans lequel le au moins un élément de décélération passif (22) est disposé entre l'accélérateur de particules (4) et le filtre d'énergie (20) et/ou est disposé derrière le filtre d'énergie (20) dans la direction du faisceau,
**caractérisé en ce que** le au moins un élément de décélération passif (22) est positionné de manière pivotante ou déplaçable, afin de produire une variation de l'énergie du faisceau d'ions frappant le substrat (12) même avec une énergie fixe du faisceau d'ions (10) fourni par l'accélérateur de particules (4).

2. Dispositif selon la revendication 1, **caractérisé en ce que** le au moins un élément de décélération passif (22) comporte une membrane plane.

3. Dispositif selon la revendication 2, **caractérisé en ce que** l'épaisseur de la membrane plane est comprise entre 0,5 µm et 100 µm, de préférence entre 2 µm et 30 µm, plus préférentiellement entre 4 µm et 15 µm.

4. Dispositif selon la revendication 2 ou 3, **caractérisé en ce que** le matériau de la membrane plane est choisi parmi un des matériaux suivants : silicium, tungstène, carbone, titane.

5. Dispositif selon une des revendications précédentes, **caractérisé en ce que** l'accélérateur de particules (4) est un accélérateur linéaire à haute fréquence ou un cyclotron.

6. Dispositif selon la revendication 5, **caractérisé en ce que** l'accélérateur de particules (4) génère un faisceau d'ions (10) pulsé ou continu d'une énergie de 0,3 à 3,0 MeV/nucléon, de préférence de 0,5 à 3,0 MeV/nucléon, plus préférentiellement de 1,0 à 2,0 MeV/nucléon, plus préférentiellement de 1,3 à 1,7 MeV/nucléon.

7. Dispositif selon la revendication 5 ou 6, **caractérisé en ce que** l'accélérateur de particules (4), de par sa conception, ne fournit qu'une énergie fixe par nucléon pour chaque type d'ion ou que l'accélérateur de particules (4) de par sa conception ne peut délivrer que des ions dans la gamme d'énergie de 1 à 50 Mev, de sorte que, de par sa conception, moins de dix énergies ajustables du faisceau d'ions (10) sont possibles.

8. Dispositif selon une des revendications précédentes, **caractérisé en ce que** les supports (16, 18) du filtre d'énergie (20) et du au moins un élément de décélération (22) sont formés en un seul tenant l'un avec l'autre.

9. Dispositif selon une des revendications précédentes, **caractérisé en ce que** le au moins un élément de décélération (22) et le filtre d'énergie (20) sont disposés dans une chambre à vide séparée, qui peut être fermée par des vannes et qui est disposée à l'intérieur de la chambre d'irradiation (8) ou directement juxtaposée à la chambre d'irradiation (8).

10. Procédé d'implantation de particules dans un substrat (12) utilisant le dispositif selon une quelconque des revendications 1 à 9, comprenant les étapes suivantes :
- la génération d'un faisceau d'ions (10) d'ions chargés positivement au moyen d'une source de particules (2) et d'un accélérateur de particules (4) ; et
- l'irradiation du substrat (12) maintenu par le support de substrat (30) avec le faisceau d'ions (10) en interposant le au moins un élément de décélération passif (22) et le filtre d'énergie (20).

11. Procédé selon la revendication 10, **caractérisé en ce qu'**une variation de l'énergie du faisceau d'ions (10) frappant le substrat (12) est déterminée en utilisant une sélection appropriée du nombre et des propriétés, telles que le matériau et/ou l'épaisseur de l'élément de décélération (22) ou des éléments de décélération (22), à travers lesquels le faisceau d'ions (10) passe après l'accélérateur de particules (4).

12. Procédé selon la revendication 10 ou 11, **caractérisé en ce qu'**un élément de décélération (22) est présent en plusieurs exemplaires et ces éléments de décélération (22) sont amenés alternativement, de préférence tournés, sur le trajet du faisceau d'ions (10).

13. Procédé selon la revendication 12, **caractérisé en ce que** plusieurs filtres d'énergie (20) sont présents, qui sont amenés alternativement sur le trajet du faisceau d'ions (10), dans lequel les filtres d'énergie (20) et les éléments de décélération (22) sont entraînés par le même mécanisme de rotation (32).
